# EUROPÄISCHE PATENTSCHRIFT

(11) **EP 3 121 918 B1**
(45) Veröffentlichungstag und Bekanntmachung des Hinweises auf die Patenterteilung: **12.09.2018**
(21) Anmeldenummer: 15177555.8
(22) Anmeldetag: 20.07.2015
(51) Int. Cl.: H02G 1/12

(54) **VORRICHTUNG ZUR BEARBEITUNG VON KABEL**
DEVICE FOR PROCESSING CABLE
DISPOSITIF DESTINE AU TRAITEMENT DE CABLES

(43) Veröffentlichungstag der Anmeldung: 25.01.2017
(73) Patentinhaber: Komax Holding AG, 6036 Dierikon (CH)
(72) Erfinder: VIVIROLI, Stefan, 6048 Horw (CH)
(74) Vertreter: Inventio AG

(56) Entgegenhaltungen:
- EP-A1- 1 901 026
- EP-A2- 1 515 403
- WO-A1-2004/095894
- JP-A- H02 133 016
- JP-A- H11 299 036
- JP-A- 2000 354 315
- US-A1- 2014 041 486

## Beschreibung

Die Erfindung betrifft eine Vorrichtung zum Bearbeiten, insbesondere Abisolieren, Schneiden, Kontaktieren, Konfektionieren, Verbinden, Messen oder Prüfen, von Kabel, das wenigstens einen Metallleiter umfasst, der von einer Isolationsschicht, gegebenenfalls einem Kabelmantel umschlossen ist.

Zur Verbindung elektrischer Module werden Kabel eingesetzt, die typischerweise mittels Steckkontakten, Steckverbindern oder Lötverbindungen mit Anschlüssen eines zugehörigen elektrischen Moduls verbunden und zu diesem Zweck zuvor an den Enden abisoliert werden. Gelegentlich werden Kabelteile durch Spleissvorrichtungen miteinander verbunden, wie sie z.B. aus der US4520229A bekannt sind.

Die EP1515403A2 offenbart eine Kabelbearbeitungsmaschine mit einer Kabelvorschubeinrichtung und zwei Schwenkarmen, welche die voreilenden und die nacheilenden Enden eines Kabelstücks mittels Greifern seitlich der Kabellängsachse angeordneten Bearbeitungsstationen, Crimppressen oder Tüllenbestücker, zuführen können. Mittels Trenn- oder Abisoliermessern wird das Kabel zuvor aufgetrennt und an den Enden abisoliert. Dabei ist darauf zu achten, dass der elektrische Leiter bei der Abisolierung durch das Werkzeug bzw. das Abisoliermesser nicht verletzt wird.

Die EP2717399A1 offenbart ein Verfahren zum Abisolieren eines sich in einer Längsrichtung erstreckenden Kabels, bei dem eine Isolation mittels Abisoliermessern angeschnitten und anschliessend durch Verschieben der Abisoliermesser in Längsrichtung abgezogen wird. Während des Abziehvorgangs wird jeweils die Längsposition der Abisoliermesser an den Stellen registriert, an denen die Abisoliermesser den Kabelleiter berühren. Anhand der Anzahl der registrierten Längspositionen bzw. Leiterberührungen wird die Qualität des abisolierten Kabels bewertet.

Zum Detektieren der Leiterberührungen wird eine Messeinrichtung verwendet, die mit einem kapazitiven Sensor ausgerüstet ist. Der kapazitive Sensor ist mit den Abisoliermessern verbunden und derart ausgebildet, dass eine Berührung des leitfähigen Messers mit dem Leiter des Kabels anhand einer Kapazitätserhöhung detektiert werden kann.

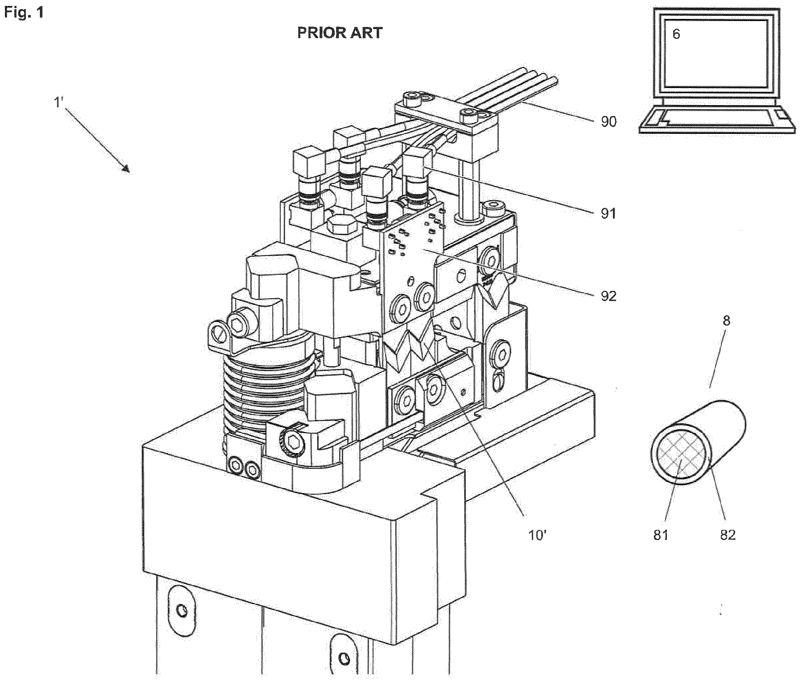

Die nachstehende Fig. 1 zeigt eine entsprechend ausgestaltete Vorrichtung 1' zur Abisolierung von Kabeln, die mit einer Messeinrichtung 6 versehen ist, die der Kapazitätsmessung dient. Dazu ist die Messeinrichtung 6 über abgeschirmte Messkabel 90, Steckverbinder 91 und eine Kontaktierungsplatte 92 mit dem Abisoliermesser 10' verbunden. Das Abisoliermesser 10' dient als erste Elektrode eines Kondensators, dessen zweite Elektrode durch die Masse der Abisoliervorrichtung gebildet wird. Falls das Abisoliermesser 10' während des Arbeitsprozesses die Ummantelung oder Isolation 82 des bearbeiteten Kabels 8 durchtrennt und mit dem elektrischen Leiter 81 in Kontakt gerät, erhöht sich die Kapazität entsprechend. Durch die Messung der auftretenden Kapazitätsänderungen kann in der Folge die Kontaktierung des elektrischen Leiters 81 durch das Abisoliermesser 10' detektiert werden.

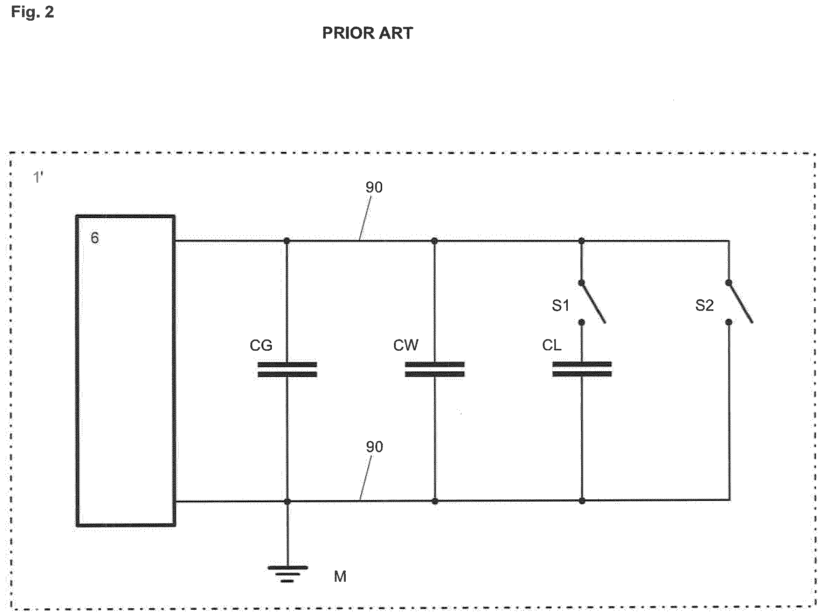

Das diesbezügliche elektrische Ersatzschaltbild der Vorrichtung 1' von Fig. 1 ist in Fig. 2 gezeigt. Das Abisoliermesser 10' weist ohne Kabelberührung eine Kapazität CW gegenüber Erdpotential M auf. Das Kabel 8 bzw. der elektrische Leiter 81 weist eine Leiterkapazität CL gegenüber Erdpotential M auf. Sobald das Abisoliermesser 10' den Kabelleiter 81 berührt, wird der in Fig. 2 gezeigte Schalter S1 geschlossen, wodurch sich die Kapazitäten CW des Abisoliermessers 10' und CL des Kabelleiters 81 addieren. Sollte der Kabelleiter 81 die Masse M der Abisoliervorrichtung 1' berühren, so wird der in Fig. 2 gezeigte Schalter S2 geschlossen. Der Kondensator CG repräsentiert die Grundkapazität der Vorrichtung 1'.

Beim Betrieb der Vorrichtung wird das Messkabel 90 mit jeder Bewegung des daran angeschlossenen Abisoliermessers 10' bewegt und deformiert, was eine aufwändige Kabelführung erfordert, zu Kabelbrüchen führen und Kapazitätsänderungen hervorrufen kann, welche die Messung beeinflussen. Sofern das Abisoliermesser 10' zu Service-und Umrüstungszwecken aus-und wieder eingebaut werden muss, so müssen die Messkabel 90 jedes Mal aus-und wieder eingesteckt werden. Dies führt zu einem entsprechenden zeitlichen Aufwand und kann zu Fehlern führen, falls die Messkabel 90 versehentlich vertauscht oder nicht mehr eingesteckt werden. Qualitativ hochwertige Steckverbinder 91 und abgeschirmte Messkabel 90 verursachen zudem einen relativ hohen Kostenaufwand und Montageaufwand bei der Herstellung der Abisoliervorrichtung 1'.

Die mit dem Werkzeug verbundenen Kabel beeinträchtigen zudem die Beweglichkeit des Werkzeugs. Insbesondere sind mehrfache Umdrehungen in dieselbe Achse kaum realisierbar.

Bei Abisoliervorrichtungen mit rotierenden Teilen, insbesondere rotierenden Messern, besteht zudem das Problem, dass eine feste Verkabelung technisch kaum realisierbar ist. Die genannten Probleme verbleiben unabhängig davon, ob das Werkzeug linear oder entlang einer Kurve bewegt wird.

Die beschriebenen Probleme sind nicht auf Abisoliervorrichtungen beschränkt, sondern treten bei allen Vorrichtungen zur Bearbeitung von Kabeln und Leitungen auf, bei denen ein mit einem Kabel verbundenes Werkzeug bewegt wird.

Die EP1772701A1 offenbart z.B. eine Vorrichtung zur Bestimmung des Durchmessers des elektrischen Leiters eines Kabels, der an einer ersten Position mit einem Wechselspannungssignal beaufschlagt wird, das an einer zweiten Position mittels eines kapazitiven Sensors wieder ausgekoppelt und einer Messeinrichtung zugeführt wird. Zur Bestimmung des Leiterdurchmessers werden verschiebbar gehaltene Werkzeuge, Kontaktelemente oder Kontaktmesser, die über ein Anschlusskabel mit einem bestimmten elektrischen Potential verbunden sind, gegen den elektrischen Leiter geführt, bis dieser kontaktiert wird und das Wechselspannungssignal eine Änderung erfährt und der Leiterdurchmesser dadurch festgestellt werden kann.

Auch bei dieser Vorrichtung sind die mit dem Werkzeug verbundenen Kabel einer mechanischen Belastung unterworfen und verursachen bei der Herstellung und Wartung einen entsprechenden Aufwand. Das Werkzeug ist ebenfalls in der Beweglichkeit beschränkt.

Der vorliegenden Erfindung liegt daher die Aufgabe zu Grunde, die Nachteile des Standes der Technik zu überwinden und eine verbesserte Vorrichtung zum Bearbeiten, insbesondere zum Abisolieren, Schneiden, Kontaktieren, Konfektionieren, Verbinden, Messen oder Prüfen eines Kabels anzugeben, welches wenigstens einen isolierten elektrischen Leiter aufweist.

Insbesondere ist eine verbesserte Vorrichtung zur Bearbeitung eines Kabels mit einem elektrischen Leiter anzugeben, der bei der Kabelbearbeitung kontaktiert oder nicht kontaktiert werden soll, wobei die erwünschte oder unerwünschte Kontaktierung des elektrischen Leiters vorteilhaft messbar sein soll.

Einschränkungen, insbesondere Einschränkungen hinsichtlich der Beweglichkeit des Werkzeugs, denen die bekannten Vorrichtungen unterworfen sind, sollen vermieden werden. Das Werkzeug soll frei bewegbar und insbesondere beliebig oft um eine Achse drehbar sein.

Die erfindungsgemässe Vorrichtung soll einfach und mit reduzierten Kosten herstellbar sein und mit einem reduzierten Aufwand gewartet werden können.

Beim Betrieb der Vorrichtung sollen störende Einflüsse auf das Messergebnis weitgehend vermieden oder mit einfachen Massnahmen beseitigt werden können.

Diese Aufgabe wird durch eine Vorrichtung gemäss Anspruch 1 gelöst. Vorteilhafte Ausgestaltungen der Erfindung sind in

Die JP2000354315A offenbart eine weitere Vorrichtung zum Abisolieren eines sich in einer Längsrichtung erstreckenden Kabels, bei der eine Detektionsvorrichtung durch ein Kabel mit einem Abisoliermesser verbunden ist. Die JPH02133016 offenbart eine Vorrichtung zum Abisolieren eines Kabels mit einem Kondensator. Der vorliegenden Erfindung liegt daher die Aufgabe zu Grunde, die Nachteile des Standes der Technik zu überwinden und eine verbesserte Vorrichtung zum Bearbeiten, insbesondere zum Abisolieren, Schneiden, Kontaktieren, Konfektionieren, Verbinden, Messen oder Prüfen eines Kabels anzugeben, welches wenigstens einen isolierten elektrischen Leiter aufweist. Insbesondere ist eine verbesserte Vorrichtung zur Bearbeitung eines Kabels mit einem elektrischen Leiter anzugeben, der bei der Kabelbearbeitung kontaktiert oder nicht kontaktiert werden soll, wobei die erwünschte oder unerwünschte Kontaktierung des elektrischen Leiters vorteilhaft messbar sein soll. Einschränkungen, insbesondere Einschränkungen hinsichtlich der Beweglichkeit des Werkzeugs, denen die bekannten Vorrichtungen unterworfen sind, sollen vermieden werden. Das Werkzeug soll frei bewegbar und insbesondere beliebig oft um eine Achse drehbar sein.

Die erfindungsgemässe Vorrichtung soll einfach und mit reduzierten Kosten herstellbar sein und mit einem reduzierten Aufwand gewartet werden können.

Beim Betrieb der Vorrichtung sollen störende Einflüsse auf das Messergebnis weitgehend vermieden oder mit einfachen Massnahmen beseitigt werden können.

Diese Aufgabe wird durch eine Vorrichtung gemäss Anspruch 1 gelöst. Vorteilhafte Ausgestaltungen der Erfindung sind in weiteren Ansprüchen angegeben.

Die Vorrichtung, die dem Bearbeiten, insbesondere Abisolieren, Schneiden, Kontaktieren, Konfektionieren, Verbinden, Messen oder Prüfen, eines Kabels dient, welches wenigstens einen isolierten elektrischen Leiter aufweist, umfasst ein Werkzeug, das relativ zum Kabel bewegbar ist und eine Messeinrichtung, mittels der die Kontaktierung des elektrischen Leiters durch das Werkzeug detektierbar ist.

Erfindungsgemäss ist das Werkzeug mit einem ersten Elektrodenkörper verbunden, welcher relativ zu einem vorzugsweise stationären zweiten Elektrodenkörper bewegbar ist, sodass durch die beiden Elektrodenkörper, die durch einen Luftspalt oder ein Isolationsmaterial voneinander getrennt sind, ein Kopplungskondensator gebildet wird, über den das metallene Werkzeug an die Messeinrichtung oder an eine Wechselspannungsquelle oder an ein elektrisches Potential angekoppelt oder ankoppelbar ist.

Die erfindungsgemässe Vorrichtung kann in verschiedenen Konfigurationen realisiert werden, ohne dass das Werkzeug mittels eines oder mehrerer Kabel mit zugehörigen Kabelanschlüssen z.B. einer Messeinrichtung, einer Spannungsquelle oder einem elektrischen Potential, z.B. Masse, verbunden werden muss. Auf Kabel zur Kontaktierung des Werkzeugs und deren Montage kann somit verzichtet werden, weshalb der Kostenaufwand und der Wartungsaufwand entsprechend reduziert werden.

Der erste und der zweite Elektrodenkörper sind aus Metall gefertigt und vorzugsweise je zumindest teilweise mit einer gleitfähigen Kunststoffschicht beschichtet, sodass ein Gleitlager gebildet wird. Die isolierenden Kunststoffschichten sollen eine hohe Gleitfähigkeit aufweisen und bestehen vorzugsweise aus Teflon, ERTALON®PA, NYLATRON®, ERTACETAL®POM, ERTALYTE®PET, ERTALYTE®TX oder Hostaform. Vorzugsweise werden Kunststoffmaterialien mit einer hohen Dielektrizitätskonstante verwendet.

Der Kopplungskondensator kann somit vorteilhaft in eine Lagervorrichtung, insbesondere ein Gleitlager, integriert werden, welches zum Halten des Werkzeugs geeignet ist.

Die erfindungsgemässe Lösung erlaubt die Realisierung der Vorrichtung in unterschiedlichen Ausgestaltungen. In prinzipiellen Ausgestaltungen der Vorrichtung ist die Messeinrichtung
a) zur Messung von Änderungen der Kapazität des Werkzeugs ausgebildet, die auftreten, falls das Werkzeug mit dem elektrischen Leiter des Kabels in Kontakt tritt; oder
b) zur Überwachung eines Wechselspannungssignals ausgebildet, welches an einer ersten Position in den elektrischen Leiter einkoppelbar und an weiteren Positionen aus dem elektrischen Leiter auskoppelbar und einerseits der Messeinrichtung und andererseits, sobald das Werkzeug den elektrischen Leiter kontaktiert, über den Kopplungskondensator einem elektrischen Potential zuführbar ist; oder
c) zur Überwachung eines Wechselspannungssignals ausgebildet, welches über den Kopplungskondensator und das Werkzeug an einer ersten Position in den elektrischen Leiter einkoppelbar und an einer zweiten Position aus diesem auskoppelbar und der Messeinrichtung zuführbar ist.

Der Kopplungskondensator kann daher auf verschiedene Arten vorteilhaft eingesetzt werden, um das Werkzeug mit einem Element der elektrischen Schaltungsanordnung zu verbinden.

Der erste und der zweite Elektrodenkörper sind vorzugsweise derart dimensioniert und relativ zueinander geführt, dass einander überdeckende Flächen der beiden Elektrodenkörper und deren gegenseitiger Abstand während der gegenseitigen Drehung und/oder Verschiebung der beiden Elektrodenkörper zumindest annähernd konstant bleiben. Somit bleibt auch die Kapazität des Kopplungskondensators weitgehend konstant und die Messung der Kapazität des Werkzeugs von dessen Bewegung weitgehend unbeeinflusst.

Um allfällig verbleibende störende Einflüsse auf die Messung jedoch vollständig ausschliessen zu können, wird der Kapazitätsverlauf des Kopplungskondensators für einen vollständigen Bewegungsablauf des Werkzeugs registriert. Bei der Auswertung von Messsignalen können Nichtlinearitäten des Verlaufs der Kopplungskapazität entsprechend kompensiert werden. Z.B. wird ein Encoder bzw. Drehwinkelgeber verwendet, der während der Registrierung des Kapazitätsverlaufs und während des späteren Betriebs der Vorrichtung die jeweilige Winkellage des Werkzeugs anzeigt, sodass die Kapazität des Kopplungskondensators in Funktion der aktuellen Winkellage des Werkzeugs ermittelt und bei der Berechnung der Messergebnisse berücksichtigt werden kann.

In einer bevorzugten Ausgestaltung ist der erste Elektrodenkörper trommelförmig ausgebildet und von einer Antriebsvorrichtung innerhalb des ringförmig oder hohlzylinderförmig ausgebildeten zweiten Elektrodenkörpers drehbar gehalten.

Die Antriebsvorrichtung, mittels der das Werkzeug gedreht wird, umfasst vorzugsweise eine Antriebswelle, die den ersten Elektrodenkörper drehbar hält. Die Antriebswelle kann im gegebenenfalls von den Elektrodenkörpern gebildeten Gleitlager und/oder in einem separaten Lagerblock gelagert sein.

Vorzugsweise wird verhindert, dass durch die Lagerwelle eine elektrische Verbindung zwischen dem ersten und zweiten Elektrodenkörper resultiert. Sofern die Lagerwelle mit dem ersten Elektrodenkörper und auch mit dem Lagerblock galvanisch gekoppelt ist, so ist dieser vorzugsweise durch eine erste Isolationsschicht vom zweiten Elektrodenkörper getrennt. Angetrieben wird das Werkzeug vorzugsweise mittels eines isolierenden Antriebsriemens, der die Antriebswelle mit einem Antriebsmotor mechanisch koppelt, aber elektrisch isoliert.

Zur Isolation des zweiten Elektrodenkörpers gegenüber Erde, wird dieser vorzugsweise durch eine zweite Isolationsschicht von einem Montageelement getrennt, welches die Vorrichtung stützt. Das genannte Montageelement kann z.B. eine Basisplatte oder ein Vorrichtungssockel sein.

Der erste Elektrodenkörper hält vorzugsweise eine Werkzeughalterung, in die das wenigstens eine Werkzeug eingesetzt ist. Ferner ist im ersten Elektrodenkörper vorzugsweise eine Stellvorrichtung vorgesehen, mittels der die Werkzeughalterung und das Werkzeug betätigbar sind. Z.B. umfasst die Werkzeughalterung zwei drehbar gelagerte Hebel, an deren Frontzeiten gegeneinander gerichtete Klingen oder Abisoliermesser vorgesehen sind, die bei Betätigung der Stellvorrichtung gegeneinander oder auseinandergefahren werden.

In weiteren vorzugsweisen Ausgestaltungen ist das Werkzeug in den ersten Elektrodenkörper integriert oder einstückig mit diesem verbunden. Das Werkzeug kann auch selbst den ersten Elektrodenkörper bilden.

Z.B. ist das Werkzeug als rollenförmiger erster Elektrodenkörper ausgebildet, mittels dessen das Kabel abtastbar ist, insbesondere um Stellen zu ermitteln, an denen das Kabel eine Anomalie, wie eine Spleissverbindung, eine Isolationsschwäche oder einen Isolationsunterbruch aufweist. Sobald der rollenförmige erste Elektrodenkörper den elektrischen Leiter kontaktiert, erfolgt eine sprunghafte Änderung der gemessenen Kapazität des Werkzeugs. Mittels der Messeinrichtung können jedoch auch nicht sprunghaft eintretende Kapazitätsänderungen erfasst werden. Falls die Dicke der Isolationsschicht bzw. des Kabelmantels aufgrund eines Produktionsfehlers variiert, kann dies anhand der gemessenen Kapazitätsänderungen festgestellt werden. Auf dieselbe Weise können Spleissverbindungen detektiert werden, da bei diesen entweder eine Verbindung mit dem elektrischen Leiter mit einer Erhöhung der Werkzeugkapazität oder eine Erhöhung des Durchmessers mit einer Reduktion der Werkzeugkapazität resultiert.

Vorzugsweise ist der rollenförmige erste Elektrodenkörper im zweiten Elektrodenkörper drehbar gehalten, der seinerseits als stationäre Lagerschale ausgebildet ist. Vorzugsweise ist ein metallener zweiter Rollenkörper vorgesehen, der in einer metallenen zweiten Lagerschale drehbar gehalten und gegenüber dieser vorzugsweise mit Erdpotential verbundenen zweiten Lagerschale isoliert ist, sodass ein Rollenpaar gebildet wird, welches zur beidseitigen Führung und Kontaktierung des Kabels geeignet ist. Bei der Kontaktierung des elektrischen Leiters durch beide Rollen verdoppelt sich die Kapazitätsveränderung entsprechend.

Das wenigstens eine Werkzeug ist entsprechend der Art der Bearbeitung bedarfsweise ausgestaltet. Zum Abisolieren, Schneiden, Konfektionieren, und Kontaktieren des Kabels, des elektrischen Leiters oder der Kabelisolation wird vorteilhaft wenigstens ein Abisoliermesser vorgesehen. Vorzugsweise sind wenigstens zwei gegebenenfalls identische Werkzeuge oder Messer vorgesehen. Die Messer sind gegebenenfalls drehbar, sodass Schnitte längs und quer zur Kabelachse durchgeführt werden können.

Zum Kontaktieren, Messen oder Prüfen des Kabels, des elektrischen Leiters oder der Kabelisolation werden vorzugsweise Kontaktmesser, Kontaktstifte, Kontaktspitzen oder Rollen vorgesehen. Ferner können Zangen und Scherelemente als Werkzeuge eingesetzt werden.

Die erfindungsgemässe Messeinrichtung, die mit wenigstens einem Prozessor, gegebenenfalls einem Signalprozessor, Speichereinheiten, Schnittstelleneinheiten und vorzugsweise Kommunikationseinheiten versehen ist, umfasst vorzugsweise auch Steuermittel, die es erlauben, die Vorrichtung in Abhängigkeit der ermittelten Messwerte zu steuern. Vorzugsweise werden die ermittelten Messwerte durch die Messeinrichtung unter Berücksichtigung des Zustands der Steuermittel bearbeitet und ausgewertet.

Die erfindungsgemässe Vorrichtung wird nachstehend in vorzugsweisen Ausgestaltungen anhand von Zeichnungen exemplarisch beschrieben. Es zeigen:
- Fig. 1: die eingangs genannte, bekannte Abisoliervorrichtung 1', bei der eine Messeinrichtung 6 über Messkabel 90, Steckverbinder 91 und eine Kontaktplatte 92 beidseitig mit je einem Abisoliermesser 10' verbunden ist;
- Fig. 2: ein elektrisches Ersatzschaltbild der Abisoliervorrichtung 1' von Fig. 1 mit der Messeinrichtung 6 und daran angeschlossenen Kapazitäten, der Grundkapazität CG der Vorrichtung 1', der Kapazität CW des über die Messleitungen 90 angeschlossenen Abisoliermessers 11' sowie der Kapazität CL des elektrischen Leiters 81 des Kabels 8;
- Fig. 3: eine erfindungsgemässe Vorrichtung 1 zur Bearbeitung bzw. Abisolierung eines Kabels 8, die einen stationären Elektrodenkörper 22 und einen drehbar gelagerten, mit Abisoliermessern 10 versehenen bewegten Elektrodenkörper 21 aufweist, die einen Kopplungskondensator CK bilden;
- Fig. 4: ein elektrisches Ersatzschaltbild der Abisoliervorrichtung 1 von Fig. 3 mit der Messeinrichtung 6 und daran angeschlossenen Kapazitäten, die Grundkapazität CG1 der stationären Teile der Vorrichtung 1, die über den Kopplungskondensator CK mit der Kapazität CG2 der bewegten Teile 11, 21, 32 der Vorrichtung 1 und der Kapazität CW der Abisoliermesser 10 verbunden ist, sowie die Kapazität CL des elektrischen Leiters 81 des Kabels 8;
- Fig. 5a: eine erfindungsgemässe Vorrichtung 1 zur Bearbeitung bzw. Abisolierung eines Kabels 8, die einen stationären Elektrodenkörper 22 und einen daran verschiebbar gelagerten, mit Abisoliermessern 10 versehenen bewegten Elektrodenkörper 21 aufweist, die einen Kopplungskondensator CK bilden;
- Fig. 5b: die Vorrichtung 1 von Fig. 5a, bei der die Messeinrichtung 6 Änderungen eines Wechselspannungssignals überwacht, welches von einer Wechselspannungsquelle 60 entweder direkt oder über den Kopplungskondensator CK und das Abisoliermesser 10 in den elektrischen Leiter 81 eines Kabels 8 eingekoppelt wird;
- Fig. 6: die erfindungsgemäss weitergebildete Vorrichtung 1 gemäss der EP1772701A1; und
- Fig. 7: eine erfindungsgemässe Vorrichtung 1 zur Bearbeitung eines Kabels 8 mit einer Anomalie an einer Position, an der der elektrische Leiter 81 hervortritt oder ein Spleiss vorgesehen ist, der zwei Kabelteile 8', 8" miteinander verbindet.

Fig. 1 zeigt die eingangs beschriebene bekannte Abisoliervorrichtung 1', bei der eine Messeinrichtung 6 über Messkabel 90, Steckverbinder 91 und eine Kontaktplatte 92 beidseitig mit je einem Abisoliermesser 10' verbunden ist. Gezeigt sind ferner die mit den Messkabeln 90 verbundene Messeinrichtung 6 und ein Kabel 8, welches einen elektrischen Leiter 81 und einen Kabelmantel 82 umfasst.

Fig. 2 zeigt das eingangs beschriebene elektrische Ersatzschaltbild der Abisoliervorrichtung 1' von Fig. 1.

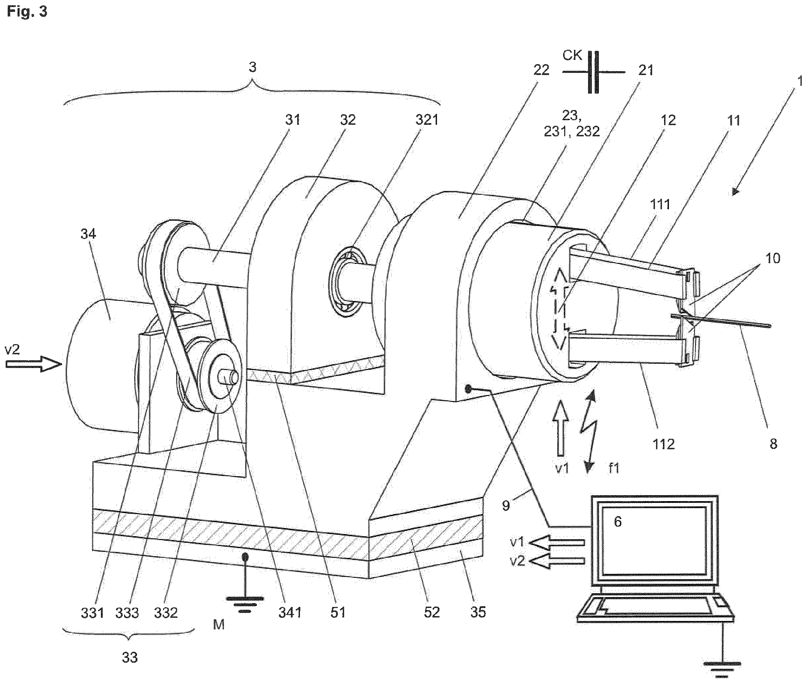

Fig. 3 zeigt eine erfindungsgemässe Vorrichtung 1 zur Bearbeitung bzw. Abisolierung eines Kabels 8. Die Vorrichtung 1 umfasst einen bewegten ersten Elektrodenkörper 21, der innerhalb eines stationären zweiten Elektrodenkörpers 22 von einer Antriebswelle 31 einer Antriebsvorrichtung 3 drehbar gehalten ist. Die beiden Elektrodenkörper 21, 22 sind galvanisch voneinander getrennt und bilden einen Kopplungskondensator CK. Die Antriebswelle 31, die innerhalb eines Lagerblocks 32 mittels eines Kugellagers 321 drehbar gelagert ist, hält am frontseitigen Ende den ersten Elektrodenkörper 21 und am rückseitigen Ende ein erstes Getrieberad 331 eines Getriebes 33, das über einen Antriebsriemen 333 mit einem zweiten Getrieberad 332 gekoppelt ist. Das zweite Getrieberad 332 ist mit der Motorwelle 341 eines Antriebsmotors 34 verbunden. Damit die galvanische Trennung zwischen den Elektrodenkörpern 21, 22 durch die Antriebsvorrichtung 3 nicht beeinträchtigt wird, ist der Lagerblock 32 durch eine erste Isolationsschicht 51 vom zweiten Elektrodenkörper 22 getrennt. Zudem besteht der Antriebsriemen 333 vorzugsweise aus einem isolierenden Material. Stattdessen oder zusätzlich können auch die Getrieberäder 331, 332 aus einem isolierenden Material gefertigt sein. Der zweite Elektrodenkörper 22 ist durch eine zweite Isolationsschicht 52 von einem Montageelement bzw. Vorrichtungssockel 35 galvanisch getrennt.

Der erste Elektrodenkörper 21 ist trommelförmig ausgebildet und umfasst eine Werkzeughalterung 11 mit zwei Werkzeughebeln 111, 112, die frontseitig je ein Abisoliermesser 10 halten. Im ersten Elektrodenkörper 21 ist zudem eine in Fig. 3 schematisch gezeigte Stellvorrichtung 12 angeordnet, mittels der die Werkzeughebel 111, 112 gegeneinander führbar sind, um eine Isolationsschicht bzw. den Kabelmantel eines Kabels 8 aufzuschneiden und gegebenenfalls abzuziehen. Die Abisoliermesser 10 sind vorzugsweise durch die Werkzeughalterung 11 mit dem ersten Elektrodenkörper 21 galvanisch gekoppelt.

Die beiden Elektrodenkörper 21, 22 sind vorzugsweise durch einen Luftspalt 23 voneinander getrennt. Die einander zugewandten Flächen der beiden Elektrodenkörper 21, 22 können hingegen auch mit gleitfähigen Kunststoffschichten 231, 232 beschichtet sein, die gleitend aneinander anliegen. Dadurch wird ein Gleitlager gebildet, welches die erste Elektrode 21 drehbar hält. In diesem Fall kann auf die Lagerung durch den Lagerblock 32 verzichtet und die Vorrichtung 1 kleiner dimensioniert werden.

Um die Kontaktierung des elektrischen Leiters 81 des Kabels 8 durch die Abisoliermesser 10 detektieren zu können, wird die Kapazität der Werkzeuge 10 gegenüber Potential M gemessen. Dazu werden die Abisoliermesser 10 kapazitiv über den Kondensator CK und weiter über eine Anschlussleitung 9 an die Messeinrichtung 6 angekoppelt.

Die Messeinrichtung 6 ist vorzugsweise als Mess- und Steuervorrichtung ausgebildet und umfasst vorzugsweise Steuermodule, mittels denen die Vorrichtung 1, insbesondere die Stellvorrichtung 12 und der Antriebsmotor 34 steuerbar sind. In Fig. 3 sind Steuerleitungen durch Pfeile v1, v2 symbolisiert.

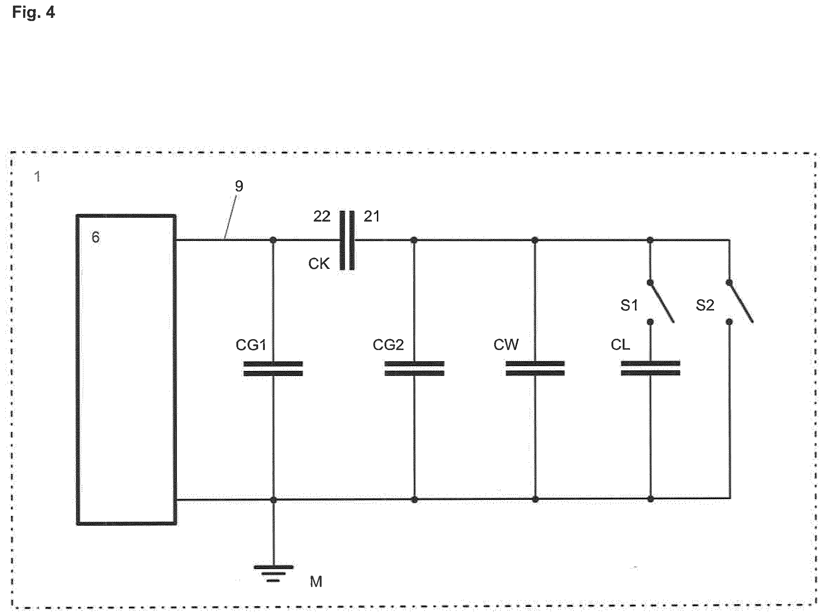

Fig. 4 zeigt ein elektrisches Ersatzschaltbild der Abisoliervorrichtung 1 von Fig. 3 mit der Messeinrichtung 6 und daran angeschlossenen Kapazitäten, der Grundkapazität CG1 der stationären Teile der Vorrichtung 1, die über den durch die beiden Elektrodenkörper 21, 22 gebildeten Kopplungskondensator CK mit der Grundkapazität CG2 der bewegten Teile 11, 21, 31 der Vorrichtung 1, der Kapazität CW der Abisoliermesser 10 sowie der Kapazität CL des elektrischen Leiters 81 des Kabels 8 verbunden ist, falls das Werkzeug 10 den elektrischen Leiter 81 kontaktiert und der Schalter S1 entsprechend geschlossen wird. Sofern das Messer 10 oder die elektrische Leitung 81 in Kontakt mit Masse M gerät, wird der Schalter S2 geschlossen.

Sofern die Schalter S1 und S2 geöffnet sind, resultiert die Gesamtkapazität = CG1 + (CK*(CG2+CW)) / (CK+CG2+CW)
Sobald der Schalter S1 geschlossen wird, resultiert die Gesamtkapazität = CG1 + (CK*(CG2+CW+CL)) / (CK+CG2+CW+CL)
Die resultierende Kapazität bei Öffnen oder Schliessen des Schalters S1 wird vorzugsweise mittels einer Schaltungsanordnung gemessen, die eine Messbrücke mit zwei Brückenzweigen umfasst.

An den ersten Brückenzweig wird die zu messende Kapazität und an den zweiten Brückenzweig wird eine Referenzkapazität angeschlossen, wie dies z.B. in der DE10001129A1 beschrieben ist. Die Referenzkapazität wird vorzugsweise derart gewählt, dass die Brücke ausbalanciert ist, wenn der Schalter S1 geöffnet ist. Sobald das Werkzeug 10 den elektrischen Leiter 81 kontaktiert und der Schalter S1 entsprechend geschlossen wird, erhöht sich die gemessene Kapazität und die Messbrücke gerät aus dem Gleichgewicht.

Vorzugsweise wird eine variable Referenzkapazität gewählt, die entsprechend der Gesamtkapazität bei geöffnetem Schalter S1 eingestellt wird.

Die erfindungsgemässe Lösung mit der Realisierung eines Kopplungskondensators CK, der mit dem bewegten Werkzeug 10 verbunden wird, kann auf verschiedene Arten vorteilhaft implementiert werden.

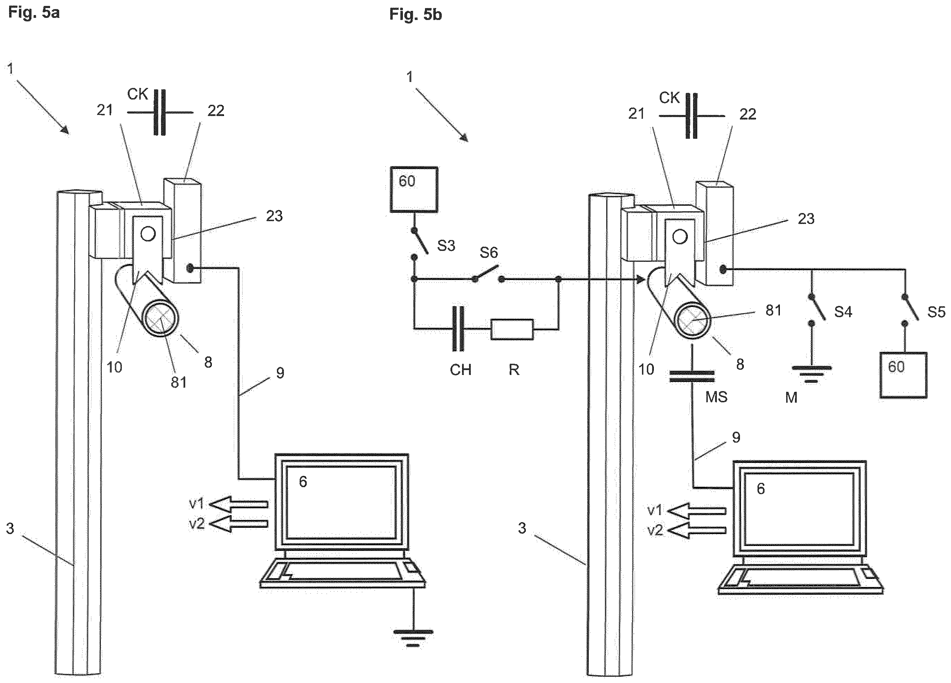

Fig. 5a zeigt eine erfindungsgemässe Vorrichtung 1 zur Bearbeitung eines Kabels 8, die einen stationären Elektrodenkörper 22 und einen daran verschiebbar gelagerten, mit Abisoliermessern 10 versehenen bewegten Elektrodenkörper 21 aufweist, die einen Kopplungskondensator CK bilden. Der bewegte erste Elektrodenkörper 21 kann z.B. mittels einer Spindel oder Zahnstange nach oben und nach unten gefahren werden. Bei der Kontaktierung des elektrischen Leiters 81 durch das Werkzeug 10 erhöht sich die gemessene Kapazität, wie dies mit Bezug auf Fig. 3 beschrieben wurde. Das Werkzeug 10 kann daher mit dem ersten Elektrodenkörper 21 auf beliebige Weise linear oder entlang einer beliebigen Kurve verschoben werden. Dabei ist zu gewährleisten, dass die Kapazität des Kopplungskondensators CK konstant bleibt oder Änderungen korrekt kompensiert werden. Dazu wird der erste Elektrodenkörper 21 über den gesamten Laufweg von einem zum anderen Anschlag verschoben und gleichzeitig werden Änderungen der Kapazität CK registriert, die bei der Berechnung der Gesamtkapazität entsprechend berücksichtigt werden. Nebst den Änderungen der Kapazität CK können auch andere Messeinflüsse kompensiert werden, welche durch die Bewegung verursacht werden.

Fig. 5b zeigt die Vorrichtung 1 von Fig. 5a, bei der die Messeinrichtung 6 Änderungen eines Wechselspannungssignals überwacht, welches von einer Wechselspannungsquelle 60 entweder direkt oder über den Kopplungskondensator CK und das Abisoliermesser 10 in den elektrischen Leiter 81 eines Kabels 8 eingekoppelt wird. Die Vorrichtung 1 ist durch Betätigung von Schaltern S3, S4, S5 und S6 wahlweise konfigurierbar.

In einer ersten Konfiguration werden der dritte Schalter S3, der vierte S4 und der sechste Schalter S6 geschlossen. Über den dritten Schalter S3 und den sechsten Schalter S6 wird das von einer Wechselspannungsquelle 60 abgegebene Wechselspannungssignal an den elektrischen Leiter 81 des Kabels 8 angelegt und durch eine Messsonde oder einen Kopplungskondensator MS kapazitiv wieder ausgekoppelt und der Messeinrichtung 6 zugeführt. Sobald das Werkzeug 10 den elektrischen Leiter 81 kontaktiert, wird das Wechselspannungssignal über den Kopplungskondensator CK und den vierten Schalter S4 an Masse M gelegt. Die Messeinrichtung 6 registriert die entsprechende Änderung des von der Messsonde MS abgegebenen Signalanteils. In einer vorzugsweisen Ausgestaltung erfolgt das Anlegen des Wechselspannungssignals an den elektrischen Leiter 81 wahlweise über einen Kopplungskondensator und/oder über ein Strombegrenzungselement. Exemplarisch ist in Fig. 5b die Serienschaltung eines Hilfskondensators CH und eines Widerstands R gezeigt, die nach dem Öffnen des sechsten Schalters S6 den Ausgang der Wechselspannungsquelle 60 mit dem elektrischen Leiter 81 verbindet.

In einer zweiten Konfiguration werden die Schalter S3 und S4 geöffnet und ein fünfter Schalter S5 geschlossen. Das von der Wechselspannungsquelle 60 abgegebene Wechselspannungssignal wird nun über den fünften Schalter S5 und den Kopplungskondensator CK an den elektrischen Leiter 81 angelegt, sobald das Werkzeug 10 den elektrischen Leiter 81 kontaktiert. Das in den elektrischen Leiter 81 eingekoppelte Wechselspannungssignal wird mittels der Messsonde MS wiederum ausgekoppelt und der Messeinrichtung 6 zugeführt.

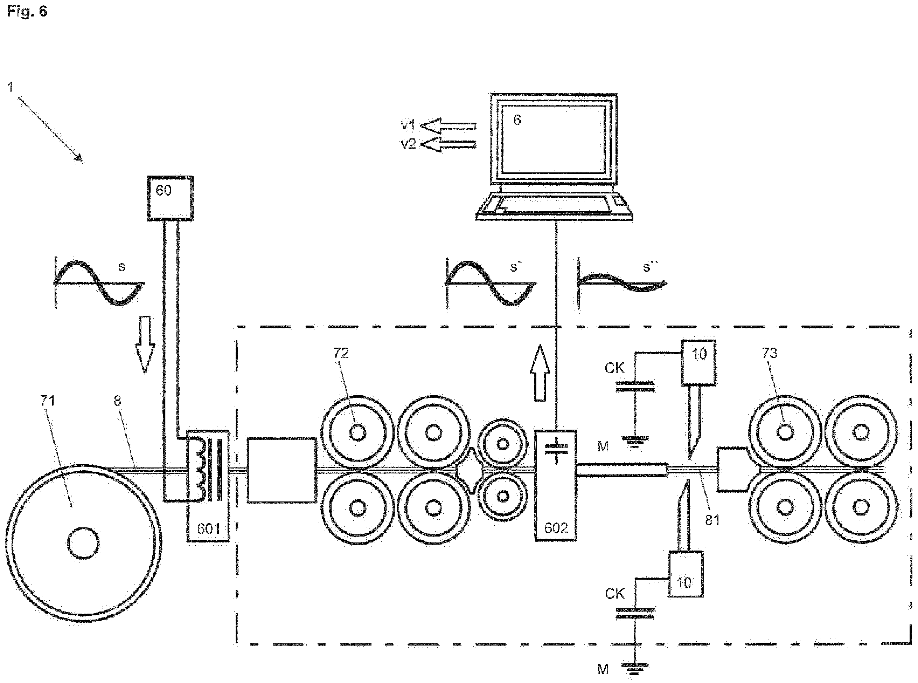

Fig. 6 zeigt die erfindungsgemäss weitergebildete Vorrichtung 1 gemäss der EP1772701A1, die u.a für die Bestimmung des Durchmessers des elektrischen Leiters 81 eines Kabels 8 verwendbar ist. Die Vorrichtung 1 umfasst eine Kabelrolle 71, von der Kabel 8 abgerollt und geführt durch Eingangsrollen 72 und Ausgangsrollen 73 durch die Vorrichtung 1 geführt wird. Vor den Eingangsrollen 72 ist eine Kopplungsvorrichtung 601 vorgesehen, über die ein Wechselspannungssignal s vorzugsweise induktiv an einer ersten Position in das Kabel 8 eingekoppelt wird. Zwischen den Eingangsrollen 72 und den Ausgangsrollen 73 ist eine Auskopplungsvorrichtung 602 vorgesehen, durch die das Wechselspannungssignal s' an einer zweiten Position vorzugsweise kapazitiv aus dem Kabel 8 ausgekoppelt und der Messeinrichtung 6 zugeführt wird.

Zur Bestimmung des Leiterdurchmessers sind verschiebbar gehaltene Werkzeuge 10, Kontaktelemente oder Kontaktmesser, vorgesehen, die je über einen Kopplungskondensator CK mit einem bestimmten elektrischen Potential, z.B. Masse M, verbunden sind. Die Realisierung des Kopplungskondensators CK erfolgt z.B. anhand der Vorrichtung von Fig. 5b (Schalter S4 geschlossen).

Falls die beiden Werkzeuge 10 gegen das Kabel 8 geführt werden und den elektrischen Leiter 81 an einer dritten Position kontaktieren, wird ein Teil des Wechselspannungssignals an dieser dritten Position ausgekoppelt, weshalb sich das an der zweiten Position ausgekoppelte Wechselspannungssignal s" entsprechend reduziert. Durch die Erfassung der Verschiebungslage der Werkzeuge 10, an der die Reduktion des Wechselspannungssignals s" aufgetreten ist, kann in der Folge der Durchmesser des elektrischen Leiters 81 ermittelt werden. Sofern die Werkzeuge 10 durch Drehung einer Spindel z.B. anhand eines Schrittmotors verschoben werden, können auch die Umdrehungen der Spindel gemessen werden. Fig. 6 zeigt exemplarisch das eingekoppelte Signal s, das nicht reduzierte ausgekoppelte Signal s' sowie das reduzierte ausgekoppelte Signal s".

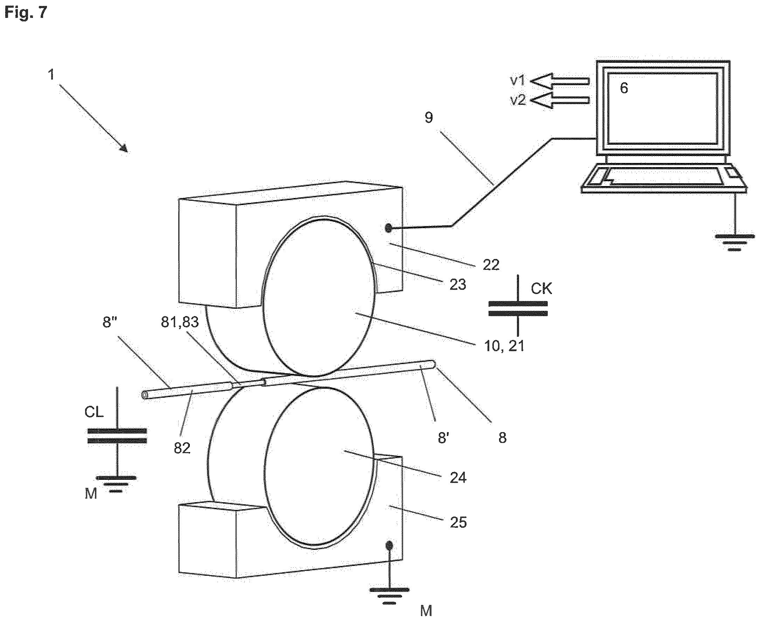

Fig. 7 zeigt eine erfindungsgemässe Vorrichtung 1 zur Bearbeitung eines Kabels 8, welches eine Anomalie an einer Position aufweist, an der der elektrische Leiter 81 hervortritt oder ein Spleiss 83 vorgesehen ist, der zwei Kabelteile 8', 8" miteinander verbindet. Die Vorrichtung 1 umfasst ein Werkzeug 10, das als Rolle ausgebildet ist und gleichzeitig als bewegter erster Elektrodenkörper 21 dient. Der rollenförmige erste Elektrodenkörper 21 ist in einem zweiten Elektrodenkörper 22 drehbar gehalten, der als stationäre Lagerschale ausgebildet ist. Die beiden Elektrodenkörper 21, 22 sind durch einen Luftspalt 23 oder Gleitelemente oder Gleitschichten voneinander getrennt und bilden den Kopplungskondensator CK. Bei der Kontaktierung des elektrischen Leiters 81 tritt wiederum eine Kapazitätsänderung auf, die von der Messeinrichtung 6 detektiert werden kann, die über eine Anschlussleitung 9 mit dem zweiten Elektrodenkörper 22 verbunden ist. Sofern die Dicke der Isolation 82 ändert, können auch entsprechende Kapazitätsänderungen erfasst werden, ohne dass eine Kontaktierung des elektrischen Leiters 81 erforderlich ist. Wie mit Bezug auf Fig. 5a beschrieben wurde, kann auch ein Wechselspannungssignal aus dem elektrischen Leiter 81 ausgekoppelt und über den Kopplungskondensator CK zur Messeinrichtung 6 übertragen werden.

In dieser bevorzugten Ausgestaltung bildet der rollenförmige erste Elektrodenkörper 21 zusammen mit einem metallenen zweiten Rollenkörper 24, der in einer metallenen zweiten Lagerschale 25 drehbar gehalten und gegenüber dieser vorzugsweise mit Erdpotential verbundenen zweiten Lagerschale 25 isoliert ist, ein Rollenpaar. Das Kabel 8 wird zwischen den beiden Rollen 21, 24 des Rollenpaars hindurchgeführt. Sofern nun beide Rollen 21, 24 den elektrischen Leiter 81 kontaktieren, verdoppelt sich die Kapazitätsänderung. Sofern ein Spleiss durch die beiden Rollen 21, 24 hindurchgeführt wird, der mit dem elektrischen Leiter 81 verbunden ist, kann dies auf gleiche Weise detektiert werden.

Wie die Ausführungsbeispiele zeigen, erlangt das Werkzeug durch Verwendung des Kopplungskondensators und Vermeidung von Messkabeln eine hohe Mobilität. Alternativ oder zusätzlich kann auch eine induktive Kopplung zwischen den beiden Elektrodenkörpern 21, 22 vorgesehen werden. Über die kapazitive oder induktive Kopplung können Energie und Signale, insbesondere Steuersignale und Messsignale bidirektional übertragen werden. Z.B. erfolgt eine induktive Kopplung zur Übertragung von Energie, die dem bewegten ersten Elektrodenkörper einen autonomen Betrieb ermöglicht. Die Messung erfolgt, wie beschrieben, vorzugsweise über den konstanten Kopplungskondensator CK. Steuersignale und Kontrollsignale können ferner auch über einen Funkkanal f1 (siehe Fig. 3) eines drahtlosen Netzwerks, wie "BLUETOOTH" zwischen einer Kommunikationseinheit im ersten Elektrodenkörper und der Messeinrichtung 6 übertragen werden.

### Bezugszeichenliste

- 1': bekannte Abisoliervorrichtung
- 1: erfindungsgemässe Vorrichtung zur Bearbeitung von Kabel
- 10': Werkzeug, Abisoliermesser
- 10: Werkzeuge, Abisoliermesser
- 11: Werkzeughalter
- 111: erster Werkzeughebel
- 112: zweiter Werkzeughebel
- 12: Stellvorrichtung
- 2: Kopplungseinheit
- 21: bewegter erster Elektrodenkörper
- 22: stationärer zweiter Elektrodenkörper
- 23: Luftspalt, Isolationsmaterial
- 231: Isolationsschicht am ersten Elektrodenkörper 21
- 232: Isolationsschicht am zweiten Elektrodenkörper 22
- 24: bewegter Hilfskörper
- 25: stationärer Hilfskörper
- 3: Werkzeugantrieb
- 31: Antriebswelle
- 32: Lagerblock
- 321: Kugellager
- 33: Getriebe
- 331: erstes Getrieberad
- 332: zweites Getrieberad
- 333: Antriebsriemen
- 34: Antriebsmotor
- 341: Motorwelle
- 35: Montageelement
- 51: erste Isolationsschicht
- 52: zweite Isolationsschicht
- 6: Messeinrichtung
- 60: Sende-und Empfangseinheit
- 601: Einkopplungsvorrichtung
- 602: Auskopplungsvorrichtung
- 71: Kabelrolle
- 72: Eingangsrollen
- 73: Ausgangsrollen
- 8: Kabel
- 8': erstes Kabelteil
- 8": zweites Kabelteil
- 81: elektrischer Leiter
- 82: Isolation, Kabelmantel
- 83: Spleissverbindung oder Isolationslücke
- 9: Anschlussleitung
- 90: Messkabel
- 91: Steckverbinder
- 92: Kontaktplatte

- CK: Kopplungskondensator
- CL: Kapazität des elektrischen Leiters 81
- CG: Grundkapazität der Vorrichtung
- CG1: Grundkapazität der stationären Vorrichtungsteile
- CG2: Grundkapazität der bewegten Vorrichtungsteile
- CH: Hilfskapazität
- CW: Kapazität des Werkzeugs bzw. des Abisoliermessers

- M: Masse, Erdpotential

- MS: kapazitive Messsonde

- S: eingekoppeltes Signal
- s': ausgekoppeltes Signal ungedämpft
- s": ausgekoppeltes Signal gedämpft
- S1: Schalter zur Anzeige der Verbindung des Werkzeugs
- S2: symbolische zweiter Schalter
- S3: dritter Schalter
- S4: vierter Schalter
- S5: fünfter Schalter
- S6: sechster Schalter

- v1: erste Steuerleitung
- v2: zweite Steuerleitung

## Patentansprüche

1. Vorrichtung (1) zum Bearbeiten eines Kabels (8), welches wenigstens einen isolierten elektrischen Leiter (81) aufweist, mit einem Werkzeug (10), das relativ zum Kabel (8) bewegbar ist und mit einer Messeinrichtung (6), mittels der die Kontaktierung des elektrischen Leiters (81) durch das Werkzeug (10) detektierbar ist, **dadurch gekennzeichnet, dass** das Werkzeug (10) mit einem ersten Elektrodenkörper (21) verbunden ist, welcher relativ zu einem zweiten Elektrodenkörper (22) bewegbar ist, sodass durch die beiden Elektrodenkörper (21, 22), die durch einen Luftspalt oder ein Isolationsmaterial (23) voneinander getrennt sind, ein Kopplungskondensator (CK) gebildet wird, über den das metallene Werkzeug (10) an die Messeinrichtung (6), an eine Wechselspannungsquelle (60) oder an ein elektrisches Potential (M) angekoppelt oder ankoppelbar ist und dass der erste und der zweite Elektrodenkörper (21, 22) relativ zueinander drehbar oder verschiebbar gehalten sind, wobei die beiden Elektrodenkörper (21, 22) derart dimensioniert und gehalten sind, dass einander überdeckende Flächen der beiden Elektrodenkörper (21, 22) und deren gegenseitiger Abstand während der gegenseitigen Drehung oder Verschiebung der beiden Elektrodenkörper (21, 22) zumindest annähernd konstant bleiben.

2. Vorrichtung (1) nach Anspruch 1, **dadurch gekennzeichnet, dass** die Messeinrichtung (6)
a) zur Messung von Änderungen der Kapazität (CL) des Werkzeugs (10) ausgebildet ist, die auftreten, falls das Werkzeug (10) mit dem elektrischen Leiter (81) in Kontakt tritt; oder
b) zur Überwachung eines Wechselspannungssignals (s) ausgebildet ist, welches an einer ersten Position in den elektrischen Leiter (81) einkoppelbar und an einer zweiten Position aus dem elektrischen Leiter (81) auskoppelbar und der Messeinrichtung (6) zuführbar ist, wobei der elektrische Leiter (81) bei Kontaktierung des Werkzeugs (10) über den Kopplungskondensator (CK) mit dem elektrischen Potential (M) verbindbar ist; oder
c) zur Überwachung eines Wechselspannungssignals (s) ausgebildet ist, welches über den Kopplungskondensator (CK) und das Werkzeug (10) bei Kontaktierung des elektrischen Leiters (81) an einer ersten Position in diesen einkoppelbar und an einer zweiten Position aus diesem auskoppelbar und der Messeinrichtung (6) zuführbar ist.

3. Vorrichtung (1) nach Anspruch 1 oder 2, **dadurch gekennzeichnet, dass** allfällige Änderungen der Überdeckung der Flächen oder Änderungen des Abstandes der beiden Elektrodenkörper (21, 22), die während der gegenseitigen Drehung oder Verschiebung auftreten, in der Messeinrichtung (6) registriert und von der Messeinrichtung (6) kompensierbar sind.

4. Vorrichtung (1) nach einem der Ansprüche 1-3, **dadurch gekennzeichnet, dass** der erste Elektrodenkörper (21) trommelförmig ausgebildet und von einer Antriebsvorrichtung (3) innerhalb des ringförmig oder hohlzylinderförmig ausgebildeten zweiten Elektrodenkörpers (22) drehbar gehalten ist.

5. Vorrichtung (1) nach Anspruch 4, **dadurch gekennzeichnet, dass** die Antriebsvorrichtung (3) eine Antriebswelle (31) umfasst, die den ersten Elektrodenkörper (21) drehbar hält und die in einem Lagerblock (32) gelagert ist, der durch eine erste Isolationsschicht (51) vom zweiten Elektrodenkörper (22) getrennt ist, und die vorzugsweise über einen isolierenden Antriebsriemen (31) mit einem Antriebsmotor (34) gekoppelt ist.

6. Vorrichtung (1) nach einem der Ansprüche 1-5, **dadurch gekennzeichnet, dass** das Werkzeug ein Abisoliermesser ist.

7. Vorrichtung (1) nach einem der Ansprüche 1-6, **dadurch gekennzeichnet, dass** der zweite Elektrodenkörper (22) durch eine zweite Isolationsschicht (52) von einem Montageelement (35) getrennt ist, welches die Vorrichtung (1) stützt.

8. Vorrichtung (1) nach einem der Ansprüche 1-7, **dadurch gekennzeichnet, dass** der erste Elektrodenkörper (21) eine Werkzeughalterung (11) hält, in die das wenigstens eine Werkzeug (10) eingesetzt ist, und dass im ersten Elektrodenkörper (21) eine Stellvorrichtung (12) vorgesehen ist, mittels der die Werkzeughalterung (11) und das Werkzeug (10) betätigbar sind.

9. Vorrichtung (1) nach einem der Ansprüche 1-8, **dadurch gekennzeichnet, dass** das Werkzeug (10) in den ersten Elektrodenkörper (21) integriert oder einstückig mit diesem verbunden ist oder dass das Werkzeug (10) den ersten Elektrodenkörper (21) bildet.

10. Vorrichtung (1) nach einem der Ansprüche 1-9, **dadurch gekennzeichnet, dass** das Werkzeug (10) als rollenförmiger erster Elektrodenkörper (21) ausgebildet ist, mittels dessen das Kabel (8) abtastbar ist, insbesondere um Stellen zu ermitteln, an denen das Kabel (8) eine Anomalie, wie eine Spleissverbindung (83), eine Isolationsschwäche oder einen Isolationsunterbruch aufweist.

11. Vorrichtung (1) nach Anspruch 10, **dadurch gekennzeichnet, dass** der rollenförmige erste Elektrodenkörper (21) im zweiten Elektrodenkörper (22) drehbar gehalten ist, der als stationäre Lagerschale ausgebildet ist.

12. Vorrichtung (1) nach Anspruch 10 oder 11, **dadurch gekennzeichnet, dass** ein metallener zweiter Rollenkörper (24) vorgesehen ist, der in einer metallenen zweiten Lagerschale (25) drehbar gehalten und gegenüber dieser vorzugsweise mit Erdpotential verbundenen zweiten Lagerschale (25) isoliert ist, sodass ein Rollenpaar (21, 24) gebildet wird, welches zur beidseitigen Führung und Kontaktierung des Kabels (8) geeignet ist.

13. Vorrichtung (1) nach einem der Ansprüche 1-12, **dadurch gekennzeichnet, dass** der erste und der zweite Elektrodenkörper (21, 22) aus Metall gefertigt und je zumindest teilweise mit einer gleitfähigen Kunststoffschicht beschichtet sind, sodass die beiden Elektrodenkörper (21, 22) über die genannten Kunststoffschichten einander anliegen, die vorzugsweise aus Teflon, ERTALON®PA, NYLATRON®, ERTACETAL®POM, ERTALYTE®PET, ERTALYTE®TX oder Hostaform bestehen, und ein Gleitlager gebildet wird.

14. Vorrichtung (1) nach einem der Ansprüche 1-13, **dadurch gekennzeichnet, dass** das Werkzeug zum Abisolieren, Schneiden, Kontaktieren, Konfektionieren, Messen oder Prüfen des Kabels (8), des elektrischen Leiters (81) oder der Kabelisolation (82) ausgebildet und verwendbar ist.

## Claims

1. A device (1) for processing a cable (8) comprising at least one insulated electrical conductor (81), with a tool (10) movable relative to the cable (8) and with a measuring device (6), by means of which contacting of the electrical conductor (81) by the tool (10) is detectable, **characterised in that** the tool (10) is connected to a first electrode element (21) which is movable relative to a second electrode element (22) so that by way of the two electrode elements (21, 22), which are separated from each other by an air gap or an insulation material (23), a coupling capacitator (CK) is formed, via which the metallic tool (10) is or can be connected to the measuring device (6), an alternating voltage source (60) or an electrical potential (M), and **in that** the first and the second electrode element (21, 22) are held so as to be rotatable or displaceable relative to each other, wherein the two electrode elements (21, 22) are dimensioned and held in such a way that surfaces of the two electrode elements (21, 22) overlapping each other and the distance between the two electrode elements (21, 22) remain approximately constant during the rotation or displacement of the two electrodes relative to each other.

2. The device (1) according to claim 1, **characterised in that** the measuring device (6)
a) is designed to measure changes in capacitance (CL) of the tool (10) which occur if the tool (10) comes into contact with the electrical conductor (81); or
b) is designed to monitor an alternating voltage signal (s) which in a first position can be coupled into the electrical conductor (81) and in a second position coupled out of the electrical conductor (81) and supplied to the measuring device (6), wherein on contacting of the tool (10) the electrical conductor (81) can be connected via the coupling capacitor (CK) to the electrical potential (M); or
c) is designed to monitor an alternating voltage signal (s) which via the coupling capacitor (CK) and the tool (10), on contacting the electrical conductor (81) can be coupled into the latter at a first position and coupled out at a second position and supplied to the measuring device (6).

3. The device (1) according to claim 1 or 2, **characterised in that** any changes in the overlapping of the surfaces or changes in the distance between the two electrode elements (21, 22) occurring during the rotation or displacement relative to each other, are recorded in the measuring device (6) and can be compensated by the measuring device (6).

4. The device (1) according to any one of claims 1 to 3, **characterised in that** the first electrode element (21) is drum-like and is rotatably held by an actuator device (3) within the annular or hollow cylindrical second electrode element (22).

5. The device (1) according to claim 4, **characterised in that** the actuator device (3) comprises a drive shaft (31) which rotatably holds the first electrode body (21) and is borne in a bearing block (32) which is separated from the second electrode body (22) by a first insulation layer (51) and which is preferably connected to a drive motor (34) via an insulating drive belt (31).

6. The device (1) according to any one of claims 1 to 5, **characterised in that** the tool is a stripping knife.

7. The device (1) according to any one of claims 1 to 6, **characterised in that** the second electrode (22) is separated from an assembly element (35), which supports the device (1), by a second insulating layer (52).

8. The device (1) according to any one of claims 1 to 7, **characterised in that** the first electrode element (21) holds a tool holder (11) into which the at least one tool (10) is inserted, and **in that** in the first electrode element (21) an actuator device (12) is provided by means of which the tool holder (11) and the tool (10) can be operated.

9. The device (1) according to any one of claims 1 to 8, **characterised in that** the tool (10) is integrated into or formed in one piece with the first electronic element (21) or **in that** the tool (10) forms the first electrode element (21).

10. The device (1) according to any one of claims 1 to 9, **characterised in that** the tool (10) is designed as a roller-shaped first electrode element (21) by means of which the cable (8) can be probed, in particular to determine points at which the cable (8) has an anomaly such as a spliced connection (83), an insulation weak point or insulation break.

11. The device (1) according to claim 10, **characterised in that** the roller-shaped first electrode element (21) is rotatably held in the second electrode element (22) which is designed as a stationary bearing shell.

12. The device (1) according to claim 10 or 11, **characterised in that** a metallic second roller element (24) is provided which is rotatably held in a metallic second bearing shell (25) and is insulated from this second bearing shell (25) which is preferably connected to earth potential, so that a roller pair (21, 24) is formed which is suitable for the bilateral guiding and contacting of the cable (8).

13. The device (1) according to an one of claims 1 to 12, **characterised in that** the first and the second electrode element (21, 22) are made of metal and each are at least partially coated with a sliding plastic layer so that the two electrode elements (21, 22) adjoin each other via said plastic layers, which are preferably made of Teflon, ERTALONA®PA, NYLATRON®, ERTACETAL®POM, ERTALYTE®PET, ERTALYTE®TX or Hostaform and form a slide bearing.

14. The device (1) according to any one of claims 1 to 13, **characterised in that** the tool is designed and useable for stripping, cutting, contacting, finishing, measuring or checking the cable (8), the electrical conductor (81) or the cable insulation (82).

## Revendications

1. Dispositif (1) de traitement d'un câble (8), qui présente au moins un conducteur électrique isolé (81), comportant un outil (10) qui est mobile par rapport au câble (8) et un dispositif de mesure (6) au moyen duquel la mise en contact du conducteur électrique (81) avec l'outil (10) est détectable, **caractérisé en ce que** l'outil (10) est connecté à un premier corps à électrodes (21) qui est mobile par rapport à un second corps à électrodes (22), de sorte qu'un condensateur de couplage (CK) est constitué par les deux corps à électrodes (21, 22) qui sont séparés l'un de l'autre par un intervalle d'air ou un matériau isolant (23), condensateur par l'intermédiaire duquel l'outil métallique (10) est couplé ou peut être couplé au dispositif de mesure (6), à une source de tension alternative (60) ou à un potentiel électrique (M) et que le premier et le second corps à électrodes (21, 22) sont maintenus de manière à pouvoir tourner ou se déplacer l'un par rapport à l'autre, les deux corps à électrodes (21, 22) étant dimensionnés et maintenus de manière à ce que les surfaces se recouvrant des deux corps à électrodes (21, 22) et leur distance réciproque restent au moins approximativement constantes pendant la rotation ou le déplacement relatif des deux corps à électrodes (21, 22).

2. Dispositif (1) selon la revendication 1, **caractérisé en ce que** le dispositif de mesure (6)
a) est conçu pour mesurer les modifications de la capacité (CL) de l'outil (10) qui surviennent dans le cas où l'outil (10) vient en contact avec le conducteur électrique (81) ;
b) est conçu pour surveiller un signal de tension alternative (s) qui est intégrable à une première position dans le conducteur électrique (81) et est dissociable à une seconde position du conducteur électrique (81) et peut être communiqué au dispositif de mesure (6), le conducteur électrique (81) étant connectable, au potentiel électrique (M) en cas de mise en contact de l'outil (10) par l'intermédiaire du condensateur de couplage (CK) ;
c) est conçu pour surveiller un signal de tension alternative (s) qui, par l'intermédiaire de condensateur de couplage (CK) et de l'outil (10), en cas de contact du conducteur électrique (81) à une première position, est intégrable dans celui-ci et est dissociable de celui-ci à une seconde position et peut être communiqué au dispositif de mesure (6).

3. Dispositif (1) selon la revendication 1 ou 2, **caractérisé en ce que** les éventuelles modifications du recouvrement des surfaces ou les modifications de la distance entre les deux corps à électrodes (21, 22) qui surviennent pendant la rotation ou le déplacement réciproque sont enregistrées dans le dispositif de mesure (6) et compensables par le dispositif de mesure (6).

4. Dispositif (1) selon une des revendications 1 à 3, **caractérisé en ce que** le premier corps à électrodes (21) est conçu en forme de tambour et est maintenu de manière à pouvoir tourner par un dispositif de commande (3) à l'intérieur du second corps à électrodes (22) conformé en anneau ou en cylindre creux.

5. Dispositif (1) selon la revendication 4, **caractérisé en ce que** le dispositif de commande (3) comprend un arbre de commande (31) qui maintient le premier corps à électrodes (21) avec possibilité de rotation et qui s'appuie dans un bloc de palier (32) qui est séparé par une première couche isolante (51) du second corps à électrodes (22) et qui est de préférence couplé par une courroie d'entraînement isolante (31) à un moteur d'entraînement (34).

6. Dispositif (1) selon une des revendications 1 à 5, **caractérisé en ce que** l'outil est un couteau de dénudage.

7. Dispositif (1) selon une des revendications 1 à 6, **caractérisé en ce que** le second corps à électrodes (22) est séparé par une seconde couche isolante (52) d'un élément de montage (35) qui soutient le dispositif (1).

8. Dispositif (1) selon une des revendications 1 à 7, **caractérisé en ce que** le premier corps à électrodes (21) maintient un support d'outil (11) dans lequel l'au moins un outil (10) est inséré, et que, dans le premier corps à électrodes (21), il est prévu un dispositif de réglage (12) au moyen duquel le support d'outils (11) et l'outil (10) sont actionnables.

9. Dispositif (1) selon une des revendications 1 à 8, **caractérisé en ce que** l'outil (10) est intégré dans le premier corps à électrodes (21) ou est raccordé à celui-ci en formant une seule pièce ou que l'outil (10) constitue le premier corps à électrodes (21).

10. Dispositif (1) selon une des revendications 1 à 9, **caractérisé en ce que** l'outil (10) est réalisé sous forme d'un premier corps à électrodes en forme de rouleau (21) au moyen duquel le câble (8) peut être balayé, en particulier pour déterminer les endroits où les câbles (8) présentent une anomalie comme un raccord épissé (83), une faiblesse de l'isolation ou une interruption de l'isolation.

11. Dispositif (1) selon la revendication 10, **caractérisé en ce que** le premier corps à électrodes en forme de rouleau (21) est maintenu de manière à pouvoir tourner dans le second corps à électrodes (22) qui est réalisé sous forme d'une coque de palier stationnaire.

12. Dispositif (1) selon la revendication 10 ou 11, **caractérisé en ce qu'**il est prévu un second corps à rouleau métallique (24) qui est maintenu de manière à pouvoir tourner dans une seconde coque de palier métallique (25) et isolé par rapport à celle-ci, la seconde coque de rouleau (25) étant de préférence raccordée au potentiel de terre, de sorte qu'il est constitué une paire de rouleaux (21, 24) qui est apte à un guidage et à une mise en contact bilatéraux du câble (8).

13. Dispositif (1) selon une des revendications 1 à 12, **caractérisé en ce que** le premier et le second corps à électrodes (21, 22) sont fabriqués en métal et sont chacun revêtus du moins partiellement d'une couche de matière plastique apte au glissement, de sorte que les deux corps à électrodes (21, 22) reposent l'un sur l'autre par l'intermédiaire des couches de plastique indiquées qui sont composées de préférence de téflon, ERTALON®PA, NYLATRON®, ERTACETAL®POM, ERTALYTE®PET, ERTALYTE®TX ou Hostaform et qu'un palier à glissement est formé.

14. Dispositif (1) selon une des revendications 1 à 13, **caractérisé en ce que** l'outil est conçu et utilisable pour le dénudage, la coupe, la mise en contact, la confection, la mesure où le contrôle du câble (8), du conducteur électrique (81) ou de l'isolation du câble (82).
